# EUROPÄISCHE PATENTANMELDUNG

(11) **EP 1 073 161 A2**
(43) Veröffentlichungstag der Anmeldung: **31.01.2001**
(21) Anmeldenummer: 00810638.7
(22) Anmeldetag: 19.07.2000
(51) Int. Cl.: H01R 13/713

(54) **Fehlerstromgeschützte Steckvorrichtung**

(30) Priorität: 30.07.1999 DE 19936056
(71) Anmelder: ABB CMC Carl Maier AG, 8200 Schaffhausen (CH)
(72) Erfinder: Mayer, Siegfried, 78244 Gottmadingen 2 (DE); Meier, Marcel, 8264 Eschenz (CH)
(74) Vertreter: ABB Patent Attorneys

(57) **Zusammenfassung**

Die fehlerstromgeschützte Steckvorrichtung weist einen Fehlerstromschutzschalter mit einer Kontaktanordnung, einem Summenstromwandler, einem Auslöser, einer Beschaltung (15) und einem Prüfkreis mit einem Prüfwiderstand (14) auf und enthält ferner Stromanschlüssen für ein Niederspannungsnetz und für einen Verbraucher. Der Fehlerstromschutzschalter und Stromanschlüsse sind auf den beiden Seiten eines überwiegend plattenförmigen Tragkörpers (6) angeordnet. Der Tragkörper (6) ist als Formteil mit integrierter Leiterbildstruktur ausgeführt. Die Leiterbildstruktur enthält Leiterbahnen (13) des Prüfkreises und der Beschaltung (15). Durch den Tragkörper (6) sind ferner Kontaktträger geführt, welche jeweils Teil einer elektrisch leitenden Verbindung zwischen einem Kontakt der Kontaktanordnung und einem der Stromanschlüsse für das Netz oder den Verbraucher sind.

Bei einer solchen Steckvorrichtung sind alle funktionswesentlichen Teile auf einem nach dem Entfernen eines umgebenden Gehäuses zentralen Tragkörper (6) angeordnet. Sie kann daher leicht montiert und leicht gewartet werden. Zudem kann durch Austauschen bestimmter modularer Bestandteile leicht eine andere Zweckbestimmung der Steckvorrichtung erreicht werden. Da der Tragkörper (6) als Formkörper mit integrierten Leiterbahnen (13) ausgebildet ist, werden bestimmte Teile von Prüfkreis und Beschaltung des Fehlerstromschutzschalters schon bei der Herstellung des Tragkörpers gebildet und brauchen dann nicht mehr als zusätzliches Bauteil montiert zu werden.

## Beschreibung

### TECHNISCHES GEBIET

Bei der Erfindung wird ausgegangen von einer fehlerstromgeschützten Steckvorrichtung nach dem einleitenden Teil von Patentanspruch 1. Fehlerstromgeschützte Steckvorrichtungen, wie Sicherheits-Stecker und Sicherheits-Steckdosen, verhüten Elektrounfälle und Brände in elektrischen Anlagen. Sie überwachen dabei angesteckte Verbraucher kontinuierlich und unterbrechen die Stromzufuhr bevor ein zur Erde abfliessender Fehlerstrom für Menschen, Tiere oder Sachen gefährlich werden kann.

### STAND DER TECHNIK

Die Erfindung nimmt auf einen Stand der Technik Bezug, wie er etwa in EP 0 641 045 B1 beschrieben ist. Eine in dieser Druckschrift angegebene und als Steckdose ausgebildete fehlerstromgeschützte Steckvorrichtung weist ein dosenförmiges Gehäuse auf, in dem aus modularen Einheiten zusammengesteckt ein FehlerstromSchutzschalter und ein Steckkontakteil angeordnet sind. Als Buchsen ausgeführte Steckanschlüsse für einen Stromverbraucher sowie Betätigungsorgane für eine Kontaktanordnung des Fehlerstrom-Schutzschalters und für einen Prüfstromkreis sind aus dem Gehäuseinneren auf die Frontseite der Steckdose geführt. Das Gehäuse weist auf der Rückseite einen Stromanschluss für den Anschluss an die Leiter eines Niederspannungsnetzes auf. Bei der Herstellung dieser Steckdose werden zunächst auf der Rückseite eines plattenförmig ausgebildeten Tragkörpers modulare Einheiten einer Kontaktanordnung, eines Antriebs, eines Prüfkreises und des Netzanschlusses eingepasst und durch Einstecken in einem als Dose ausgebildeten Teil des Gehäuse fixiert. Verbleibende modulare Einheiten des Antriebs und des Prüfkreises sowie ein Summenstromwandler, ein Magnetauslöser, eine Beschaltung und das Steckkontaktteil werden auf der Frontseite des Tragkörpers in der Dose untergebracht und die Dose mit einem den Zugang zu Betätigungselementen und zu Steckkontakten gewährleistenden Deckel abgeschlossen. Die Herstellung und die Wartung einer solchen Steckdose bedarf einer relativ grossen Anzahl an Montageschritten. Dies vor allem deswegen, da der Zugang zu vielen der modularen Einheiten erst nach dem Auseinanderstecken mehrerer Module möglich ist.

### KURZE DARSTELLUNG DER ERFINDUNG

Der Erfindung, wie sie in den Patentansprüchen angegeben ist, liegt die Aufgabe zugrunde, eine fehlerstromgeschützte Steckvorrichtung anzugeben, welche zwar kompakt ausgebildet ist, sich aber dennoch in einfacher und daher kostengünstiger Weise herstellen lässt, und welche zugleich äusserst leicht montiert und gewartet werden kann.

Die Steckvorrichtung nach der Erfindung zeichnet sich vor allem dadurch aus, dass alle ihre funktionswesentlichen Teile auf einem nach dem Entfernen eines umgebenden Gehäuses zentralen Tragkörper angeordnet sind. Alle funktionswesentlichen Teile sind leicht zugänglich. Die Steckvorrichtung nach der Erfindung kann daher leicht montiert und leicht gewartet werden, insbesondere kann durch Austauschen bestimmter modularer Bestandteile sehr einfach erreicht werden, dass die Steckvorrichtung nach dem Austausch ganz andere Anforderungen erfüllt wie eine Steckvorrichtung mit nicht ausgetauschten modularen Bestandteilen. Beispielsweise kann die Steckvorrichtung bei Ausbildung als Steckdose nach dem Austausch von Steckkontakten und der Gehäuseabdeckung statt mit Steckern, die schweizerischen Sicherheitsvorschriften entsprechen, mit Steckern zusammenarbeiten, die deutschen oder irgendwelchen anderen Sicherheitsvorschriften entsprechen. Von besonderem Vorteil ist es, dass der Tragkörper als Formkörper mit integrierten Leiterbahnen ausgebildet ist. Es können dann in einfacher Weise Kontaktträger durch den Tragkörper geführt werden. Zu beiden Seiten des Tragkörpers angeordnete Teile, insbesondere eine Kontaktanordnung eines Fehlerstromschutzschalters und Stromanschlüsse, aber auch ein Auslöser, ein Summenstromwandler und eine Beschaltung, können dann in einfacher Weise an die Kontaktstifte angesteckt und so in elektrisch leitender Weise miteinander verbunden werden. Teile von Prüfkreis und Beschaltung des Fehlerstromschutzschalters sind zudem direkt in den Tragkörper integriert und brauchen dann nicht mehr steckbar ausgebildet zu sein.

Zusätzliche Teile können eingespart werden, wenn an von Leiterbahnen freien Flächen des Tragkörpers Führungselemente für eine Prüf- und für eine Einschalttaste des Fehlerstromschutzschalters sowie bei Ausbildung als Steckdose auch rahmenförmig ausgebildete Träger zur Aufnahme von Steckkontakten eingeformt sind.

Bevorzugte Ausführungsbeispiele der Erfindung und die damit erzielbaren weiteren Vorteile werden nachfolgend anhand von Zeichnungen näher erläutert.

### KURZE BESCHREIBUNG DER ZEICHNUNGEN

In den Zeichnungen sind Ausführungsbeispiele der Erfindung vereinfacht dargestellt, und zwar zeigt:
- Fig.1: in Seitenansicht eine als Sicherheits-Steckdose ausgebildete erste Ausführungsform der fehlerstromgeschützten Steckvorrichtung nach der Erfindung,
- Fig.2: in Seitenansicht eine als Sicherheits-Stecker ausgebildete zweite Ausführungsform der fehlerstromgeschützten Steckvorrichtung nach der Erfindung,
- Fig.3: eine perspektivische Ansicht der Steckdose gemäss Fig.1 nach dem Entfernen des Steckdosen-Gehäuses,
- Fig.4: eine perspektivische Ansicht der Steckdose gemäss Fig.3 nach dem zusätzlich ein den Stromkreis der Steckdose tragender Tragkörper entfernt worden ist,
- Fig.5: eine Seitenansicht der Steckdose gemäss Fig.3,
- Fig.6: eine Seitenansicht der Steckdose gemäss Fig.4, und
- Fig.7: die Steckdose gemäss Fig.3, bei der jedoch Steckkontakte der Steckdose ausgetauscht wurden.

### WEGE ZUR AUSFÜHRUNG DER ERFINDUNG

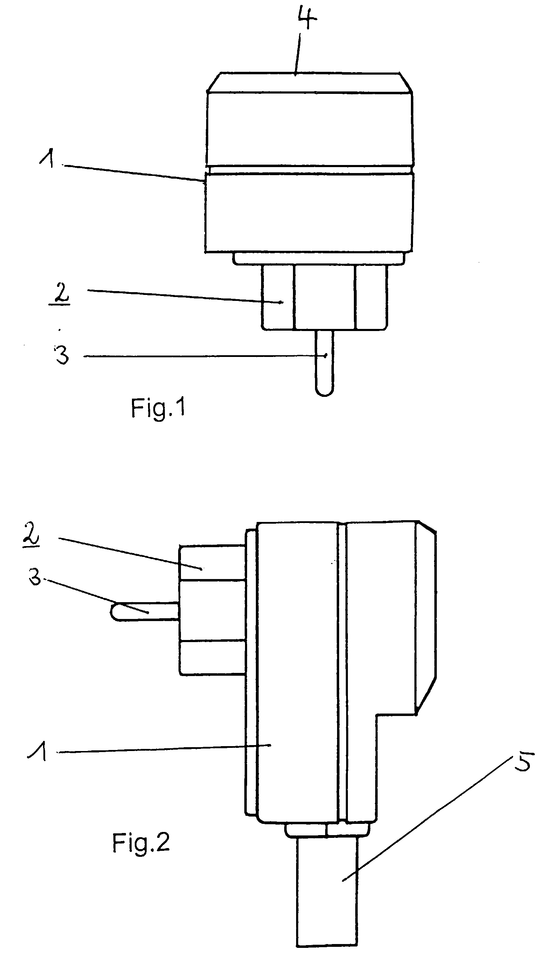

In den Figuren bezeichnen gleiche Bezugszeichen gleichwirkende Teile. Eine in Fig.1 dargestellte Steckdose weist ein dosenförmiges Gehäuse 1 auf, aus dem nach unten eine Steckerbrücke 2 mit Steckerstiften 3 und nach oben ein Steckteil 4 (Steckkontakte sind aus Fig.1 nicht ersichtlich) herausgeführt sind. Ein in Fig.2 dargestellter Stecker weist ebenfalls das dosenförmige Gehäuse 1 und die Steckerbrücke 2 mit Steckerstiften 3 auf sowie ein in das Gehäuse 1 geführtes Anschlusskabel 5.

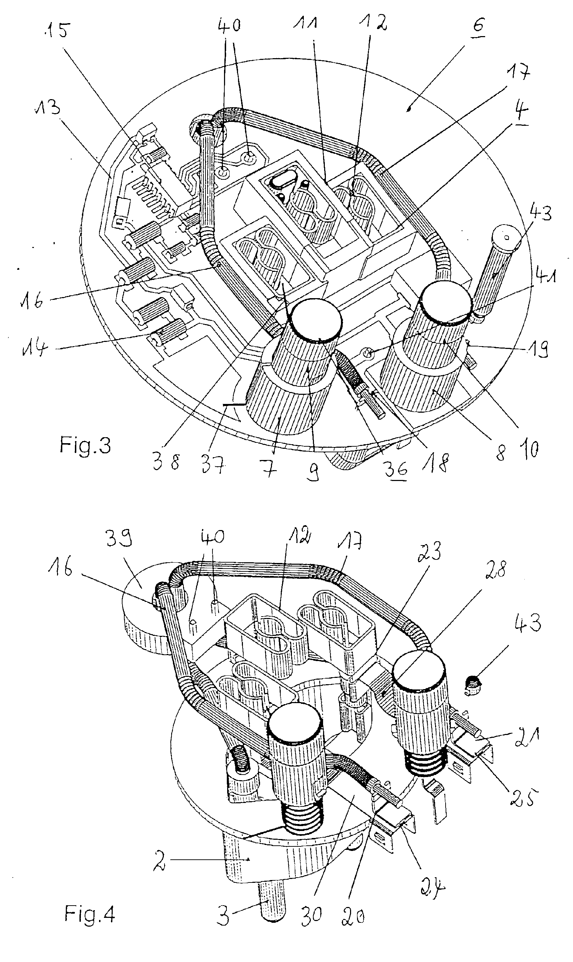

In den Gehäusen befinden sich jeweils weitgehend plattenförmig ausgeführte Körper, welche praktisch alle zwischen dem Stecker 2 und dem Steckteil 4 angeordneten stromführenden Elemente der Steckdose bzw. alle zwischen dem Stecker 3 und dem Anschlusskabel 5 angeordneten stromführenden Elemente des Steckers tragen. Ein solcher für die Steckdose gemäss Fig.1 bestimmter Tragkörper, bestückt mit dem von ihm gehaltenen Elementen des Stromkreises der Steckdose, ist in den Figuren 3, 5 und 7 dargestellt.

Der in den Figuren 3, 5 und 7 mit dem Bezugszeichen 6 gekennzeichnete Tragkörper weist überwiegend kreisscheibenförmige Gestalt auf und ist als Formteil mit integrierter Leiterbildstruktur ausgeführt. Solche Formteile sind vorzugsweise nach der MID-Technologie (Molded Interconnect Devices) hergestellt und weisen dann einen spritzgegossenen Schaltungsträger aus einem lötbaren und daher hochtemperaturbeständigen Thermoplasten auf, wie typischerweise Polyamid (PA), Polyethersulfon (PES), Polyetherimid (PEI) oder Flüssigkristallpolymer (LCP). Die Leiterbildstruktur kann auf vielfältige Art hergestellt werden, beispielsweise durch Heissprägen oder Formstempeln oder durch Galvanisieren und Ätzen oder Laserbestrahlen eines einfach spritzgegossenen Schaltungsträgers oder durch Integration in den Schaltungsträger nach einem Zweikomponenten-Spritzgussverfahren.

Aus Fig.3 ist ersichtlich, dass der Tragkörper 6 auf seiner das Steckteil 4 der Steckdose bildenden (nach oben weisenden) Seite räumliche Einformungen aufweist. Es sind dies zwei hohlzylinderförmig ausgebildete Führungselemente 7 bzw. 8 für eine Prüftaste 9 eines Fehlerstrom-Prüfkreises bzw. für eine Einschalttaste 10 der fehlerstromgeschützten Steckdose sowie drei nebeneinander angeordnete rahmenförmig ausgebildete Steckkontaktaufnahmen 11, in denen jeweils einer von drei nebeneinander angeordneten Steckkontakten 12 des Steckteils 4 gehalten wird. Um die zur Verfügung stehende geringe Fläche gut ausnutzen zu können, sind die Steckkontaktaufnahmen 11 im Bereich der Mitte und die Führungselemente 7 und 8 im Bereich des Randes des Tragkörpers 6 angeordnet. Um die Steckkontaktaufnahmen 11 ist eine bei der Herstellung der Tragkörpers gebildete Leiterbildstruktur 13 geführt, welche Leiterbahnen des einen Prüfwiderstand 14 enthaltenden Prüfkreises und einer bei der Bildung eines Fehlerstromsignals benötigten Beschaltung 15 enthält. Durch eine diametral zum Führungselement 8 angeordnete, nicht bezeichnete Öffnung des Tragkörpers sind zwei mit dem Steckerstiften 2 der Steckerbrücke 3 elektrisch leitend verbundene, flexible Leiter 16, 17 von der Unterseite (Netzseite) des Tragkörpers 6 auf dessen Oberseite (Verbraucherseite) geführt. Einer dieser beiden Leiter wird beim Einstecken der Steckerbrücke 2 mit dem Neutralleiter und der andere mit einem Phasenleiter des Netzes verbunden. Die beiden Leiter16, 17 sind zu beiden Seiten des auf der Verbraucherseite des Tragkörpers befindlichen Führungselementes 8 angeordnet und sind mit ihren freien Enden in Steckteilen 18, 19 fixiert.

Aus Fig.4 (gleiche Ansicht wie Fig.3, jedoch ist nun der Tragkörper 6 entfernt), ist zu erkennen, dass die Steckteile 18, 19 jeweils Teil eines von zwei L-förmig gewinkelt ausgeführten Kontaktträgern 20, 21 sind. Der vertikal ausgerichtete Schenkel des L jedes der beiden Kontaktträger ist durch den Tragkörper 6 geführt und trägt auf der Verbraucherseite den mit dem Neutral- oder Phasenleiter 16, 17 unter Bildung einer Steckverbindung zusammenwirkenden Steckkontakt 18, 19. Der horizontal geführte Schenkel des L liegt bei jedem der beiden Kontaktträger netzseitig auf dem Tragkörper 6 auf und trägt auf seiner von Tragkörper abgewandten Seite einen aus den Figuren 3 und 4 nicht ersichtlichen feststehenden Kontakt der Kontaktanordnung eines Fehlerstromschutzschalters der Steckdose. Der Kontakt wird vorzugsweise durch Löten auf dem horizontal geführten Schenkel fixiert.

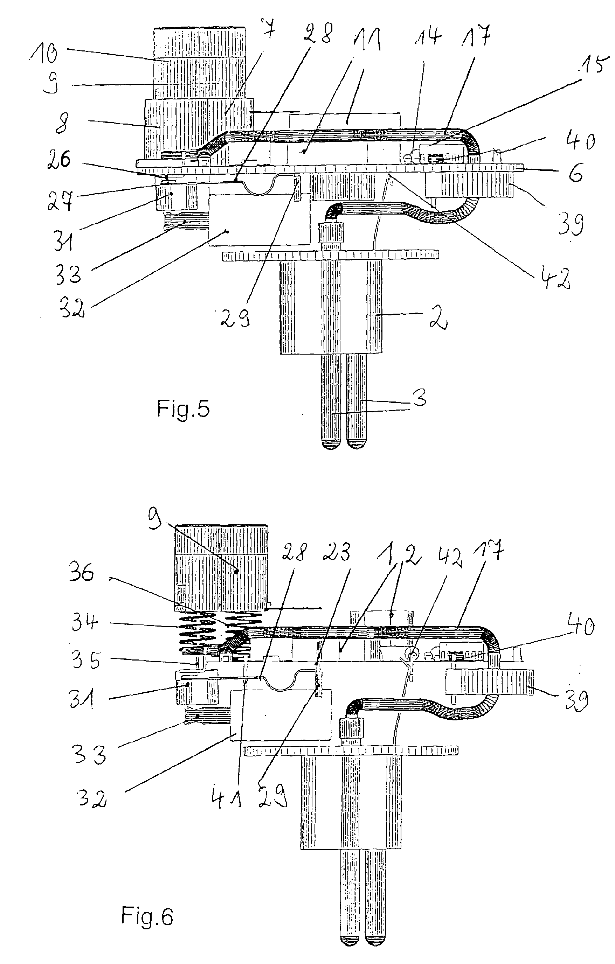

Gemäss Fig.4 sind durch den Tragkörper 6 ferner zwei Kontaktträger 22 und 23 geführt. Jeder dieser beiden Kontaktträger ist auf der Verbraucherseite mit jeweils einem der beiden aussenliegenden der drei Steckkontakte 12 und auf der Netzseite mit jeweils einem von zwei beweglichen Kontakten der Kontaktanordnung elektrisch leitend verbunden. Je ein feststehender und ein beweglicher Kontakt bilden eine von zwei Schaltstellen 24, 25. Die beiden Schaltstellen 24 und 25 und die sie enthaltenden Strompfade sind gleichartig aufgebaut und können über den Verbraucher, d.h. durch Herstellung einer Wirkverbindung zwischen den beiden aussenliegenden Steckkontakten 12, zusammengeschaltet werden. Der Aufbau des die Schaltstelle 25 enthaltenden Strompfads ist aus den Figuren 5 und 6 ersichtlich.

In diesen Figuren ist mit dem Bezugszeichen 26 der feststehende und mit dem Bezugszeichen 27 der bewegliche Kontakt der in diesem Strompfad gelegenen Schaltstelle 24 bezeichnet. Der bewegliche Kontakt 27 ist an einem freien Ende einer elektrisch leitenden Blattfeder 28 befestigt, deren anderes Ende über eine Steckverbindung 29 mit dem Kontaktträger 23 (Fig.6) elektrisch leitend verbunden ist.

Der die Schaltstelle 24 enthaltende Strompfad ist entsprechend aufgebaut und weist eine der Blattfeder 28 entsprechende Blattfeder 30 auf, welche aus Fig.4 ersichtlich ist. Die beiden die beweglichen Kontakte tragenden Enden der Blattfedern 28 und 30 sind über eine aus den Figuren 5 und 6 ersichtliche Isolierstoffbrücke 31 miteinander verbunden.

Zwischen den beiden Blattfedern ist auf der Netzseite ein Auslöser 32 an den Tragkörper 6 angeschnappt. Dieser Auslöser weist ein Betätigungsorgan 33 auf, welches bei geschlossenen Schaltstellen 24, 25 die Isolierstoffbrücke 31 gegen die Kraft der dann gespannten Blattfedern 28 und 30 hält. Beim Auftreten eines Fehlerstroms wird das Betätigungsorgan 33 nach rechts verschoben und die Isolierstoffbrücke 31 unter gleichzeitiger Öffnung der Schaltsstellen 24 und 25 nach unten geführt. Zum Einschalten wird zunächst durch Eindrücken der Einschalttaste 10 eine in die Einschalttaste eingeschnappte Rückstellfeder 35 aufgeladen und wird hierbei zugleich ein ebenfalls in die Einschalttaste 19 eingebauter Mitnehmer 35 unter die Isolierstoffbrücke geführt. Nach Freigabe der Einschalttaste entspannt sich die Rückstellfeder 34 und wird dabei die Isolierstoffbrücke 31 durch den Mitnehmer 35 unter Schliessen der Schaltstellen 24 und 25 und unter gleichzeitigem Spannen der Blattfedern nach oben geführt. Zugleich wird das Betätigungsorgan 33 nach links bewegt und dadurch die Bewegung der Isolierstoffbrücke nach unten wieder gehemmt. Der Betriebszustand des Fehlerstromschutzschalters wird durch eine mit den Leiterbahnen 13 verbundene Leuchtdiode 43 angezeigt.

Wie vorzugsweise aus Fig.3 ersichtlich ist, enthält die Prüftaste 9 eine aus elektrisch leitendem Federdraht gewickelte Druckfeder 36. Der Federdraht ist mit seinem einen Ende 37 mit einer an einen ersten Anschluss des Prüfwiderstands 14 angeschlossenen Leiterbahn der Leiterbildstruktur 13 des Prüfkreises elektrisch leitend verbunden. Bei Betätigung der Prüftaste 9 kontaktiert das andere Ende 38 des Federdrahts einen mit dem zweiten Anschluss des Prüfwiderstandes 14 verbundenen Steckkontakt 12. Bei Betätigung der Prüftaste 9 werden die beiden Leiter 16 und 17 über den Prüfwiderstand 14 kurzgeschlossen und wird so zu Prüfzweckem ein Fehlerstrom simuliert.

Ein mit dem Bezugszeichen 39 gekennzeichneter und von den beiden flexiblen Leitern 16 und 17 durchsetzter Summenstromwandler ist ebenfalls netzseitig an den Tragkörper 6 angeschnappt. Zwei Ausgänge des Summenstromwandlers 39 sind auf der Netzseite des Tragkörpers an zwei elektrisch leitende Verbindungstücke 40 angeschlossen, welche durch den Tragkörper 6 geführt und auf dessen Verbraucherseite mit der Leiterbildstruktur 13 und der Beschaltung 15 verbunden sind (Fig.5). In der Beschaltung 15 modifizierte Ausgangssignale des Summenstromwandlers 39 werden über zwei elektrisch leitende Verbindungstücke 41, welche ebenfalls durch den Tragkörper 6 geführt sind, zum Magnetauslöser 32 geleitet.

Wie aus den Figuren 5 und 6 ersichtlich ist, ist durch den Tragkörper 6 eine weitere elektrisch leitenden Verbindung 42 geführt. Diese Verbindung schliesst einen geerdeten Schutzleiter des Netzes an den in der Mitte gelegenen der drei Steckkontakte 12 an und ist von zwei federnd gegeneinander geführten Bügeln gebildet, von denen der eine mit den Steckkontakt 12 und der andere mit dem von Netz an die Steckerbrücke 3 geführten Schutzleiter verbunden ist.

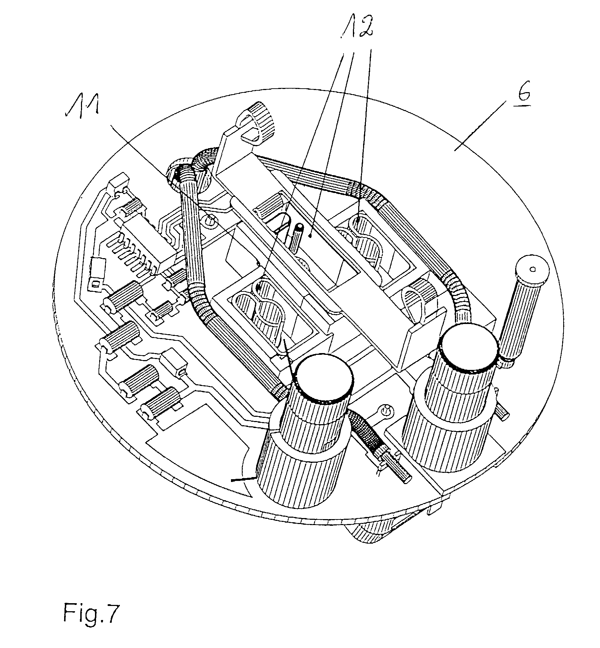

Möglicherweise defekte Teile der Steckdose können nach Öffnen des Gehäuses durch Lösen von Steckverbindungen rasch entfernt werden. Nach dem Einstecken von Ersatzteilen kann die Steckdose problemlos wieder zusammengebaut werden. Von besonderem Vorteil ist es hierbei, dass Fehlerstromschutzschalter und Dosenteil unabhängig voneinander sind. So ist es leicht möglich, an unterschiedliche, z.B. schweizerische, deutsche, französische oder andere nationale, Sicherheitsvorschriften angepasste Steckdosen herzustellen, welche sich lediglich durch unterschiedliche Ausbildung des Steckkontaktteils 4 voneinander unterscheiden. Die nach schweizerischen Vorschriften ausgebildete Sicherheits-Steckdose gemäss den Figuren 3 bis 6 kann durch Austausch der Steckkontakte 12 sehr einfach in eine nach deutschen Sicherheitsvorschriften ausgebildete Steckdose (Fig.7) oder in eine nach einem anderen nationalen Recht ausgebildete Steckdose umgerüstet werden. Zur Herstellung von Steckvorrichtungen, wie insbesondere Steckdosen, welche nach den Sicherheitsvorschriften unterschiedlicher nationaler Rechte ausgebildet sind, wird daher lediglich eine geringe Anzahl an Bausteinen benötigt. Diese Steckvorrichtungen können daher besonders kostengünstig gefertigt und gewartet werden.

### BEZUGSZEICHENLISTE

- 1: Gehäuse
- 2: Steckerbrücke
- 3: Steckkontakte
- 4: Steckteil
- 5: Anschlusskabel
- 6: Tragkörper
- 7, 8: Führungselemente
- 9: Prüftaste
- 10: Einschalttaste
- 11: Steckkontaktaufnahmen
- 12: Steckkontakte
- 13: Leiterbahnen
- 14: Prüfwiderstand
- 15: Beschaltung
- 16, 17: flexible Leiter
- 18, 19: Steckteile
- 20, 21, 22, 23: Kontaktträger
- 24, 25: Schaltstellen
- 26: feststehender Kontakt
- 27: beweglicher Kontakt
- 28, 30: Blattfedern
- 29: Steckverbindung
- 31: Isolierstoffbrücke
- 32: Auslöser
- 33: Betätigungsorgan
- 34: Rückstellfeder
- 35: Übertragungselement
- 36: Druckfeder
- 37, 38: Enden der Drahtfeder
- 39: Summenstromwandler
- 40, 41, 42: Verbindungsstücke

## Patentansprüche

1. Fehlerstromgeschützte Steckvorrichtung mit einem eine Kontaktanordnung, einen Summenstromwandler (39), einen Auslöser (32), eine Beschaltung (15) und einen Prüfkreis mit einem Prüfwiderstand (14) enthaltenden Fehlerstromschutzschalter und mit Stromanschlüssen für ein Niederspannungsnetz und für einen Verbraucher, bei der der Fehlerstromschutzschalter und die Stromanschlüsse auf den beiden Seiten eines überwiegend plattenförmigen Tragkörpers (6) angeordnet sind, dadurch gekennzeichnet, dass der Tragkörper (6) ein Formteil mit integrierter Leiterbildstruktur ist, dass die Leiterbildstruktur Leiterbahnen (13) des Prüfkreises und der Beschaltung (15) enthält, und dass durch den Tragkörper (6) Kontaktträger (20 - 23) geführt sind, welche jeweils Teil einer elektrisch leitenden Verbindung zwischen einem Kontakt (24, 25) der Kontaktanordnung und einem der Stromanschlüsse für das Netz oder den Verbraucher sind.

2. Steckvorrichtung nach Anspruch 1, dadurch gekennzeichnet, dass durch den Tragkörper (6) eine elektrisch leitende Verbindung zwischen einem Ausgang des Summenstromwandlers (39) und einer Leiterbahn (13) der Beschaltung (15) geführt ist.

3. Steckvorrichtung nach einem der Ansprüche 1 oder 2, dadurch gekennzeichnet, dass die Leiterbahnen (13) auf einer Führungselemente (7, 8) für eine Prüf- (9) und für eine Einschalttaste (10) des Fehlerstromschutzschalters enthaltenden Verbraucherseite des Tragkörpers (6) angeordnet sind.

4. Steckvorrichtung nach Anspruch 3, dadurch gekennzeichnet, dass bei Ausbildung der Steckvorrichtung als Steckdose mit als Steckkontakten (12) ausgebildeten Stromanschlüssen für den Verbraucher in die Verbraucherseite des Tragkörpers (6) zusätzlich Steckkontaktaufnahmen (11) zum Halten der Steckkontakte (12) der Steckdose eingeformt sind.

5. Steckvorrichtung nach einem der Ansprüche 3 oder 4, dadurch gekennzeichnet, dass zu beiden Seiten des Führungselementes (8) für die Einschalttaste (10) jeweils einer von zwei ersten (20, 21) der durch den Tragkörper (6) geführten Kontaktträger (20 - 23) angeordnet ist, dass jeder dieser beiden ersten Kontaktträger auf der Verbraucherseite mit einem mit dem Netz verbindbaren Neutral- oder Phasenleiter (16, 17) und auf der von der Verbraucherseite abgewandeten Netzseite mit einem (26) von zwei feststehenden Kontakten der Kontaktanordnung elektrisch leitend verbunden ist.

6. Steckvorrichtung nach Anspruch 5, dadurch gekennzeichnet, dass die ersten Kontaktträger (20, 21) jeweils L-förmig gewinkelt ausgeführt sind, dass der vertikal ausgerichtete Schenkel des L durch den Tragkörper (6) geführt ist und auf der Verbraucherseite einen mit dem Neutral- oder Phasenleiter (16, 17) unter Bildung eines Steckverbindung zusammenwirkenden Steckkontakt (18, 19) aufweist, und dass der horizontal geführte Schenkel des L auf der Netzseite auf dem Tragkörper (6) aufliegt und einen (26) der beiden feststehenden Kontakte fixiert.

7. Steckvorrichtung nach Anspruch 5 oder 6, dadurch gekennzeichnet, dass durch den Tragkörper (6) zusätzlich zwei zweite Kontaktträger (22, 23) geführt sind, und dass jeder dieser beiden zweiten Kontaktträger (22, 23) auf der Verbraucherseite mit jeweils einem von zwei ersten der Steckkontakte (12) und auf der Netzseite jeweils mit einem (27) von zwei beweglichen Kontakten der Kontaktanordnung elektrisch leitend verbunden ist.

8. Steckanordnung nach Anspruch 7, dadurch gekennzeichnet, dass die beiden beweglichen Kontakte (27) jeweils an einem freien Ende einer von zwei elektrisch leitenden Blattfedern (28, 30) angebracht sind, deren anderes Ende über eine Steckverbindung (29) mit einem (23) der beiden zweiten Kontaktträger (22, 23) elektrisch leitend verbunden ist.

9. Steckvorrichtung nach einem der Ansprüche 3 bis 8, dadurch gekennzeichnet, dass die Prüftaste (9) eine Druckfeder (36) enthält, dass die Druckfeder (36) aus elektrisch leitendem Federdraht gewickelt ist, und dass der Draht mit seinem einen Ende (37) mit einer mit einem ersten Anschluss des mindestens einen Prüfwiderstands (14) verbundenen Leiterbahn (13) des Prüfkreises elektrisch leitend verbunden ist und bei Betätigung der Prüftaste (9) mit seinem anderen Ende (38) mit einem mit dem zweiten Anschluss des Prüfwiderstandes (14) verbundenen Steckkontakt (12) elektrisch leitend verbindbar ist.

10. Steckanordnung nach einem der Ansprüche 7 bis 9, dadurch gekennzeichnet, dass durch den Tragkörper (6) eine elektrisch leitende Verbindung (42) zwischen einem Schutzleiter und einem dritten der Steckkontakte (12) geführt ist.

11. Steckanordnung nach Anspruch 10, dadurch gekennzeichnet, dass die elektrisch leitende Verbindung von zwei federnd gegeneinander geführten Bügeln gebildet ist, von denen der eine mit dem dritten Steckkontakt (12) und der andere mit dem von Netz an die Steckerbrücke (3) geführten Schutzleiter verbunden ist.
